# EUROPEAN PATENT SPECIFICATION

(11) **EP 2 413 367 B1**
(45) Date of publication and mention of the grant of the patent: **13.09.2017**
(21) Application number: 11161929.2
(22) Date of filing: 11.04.2011
(51) Int. Cl.: H01L 29/66, H01L 29/786

(54) **Transistors, Methods of Manufacturing Transistors, and Electronic Devices Including Transistors**
Transistoren, Verfahren zur Herstellung von Transistoren und elektronische Vorrichtungen damit
Transistors, procédés de fabrication de transistors et dispositifs électroniques incluant des transistors

(30) Priority: 30.07.2010 KR 20100074404
(43) Date of publication of application: 01.02.2012
(73) Proprietor: Samsung Electronics Co., Ltd., Suwon-si, Gyeonggi-do, 443-742 (KR)
(72) Inventor: Park, Kyung-bae, 449-712, Gyeonggi-do (KR); Kim, Hyun-suk, 449-712, Gyeonggi-do (KR); Ryu, Myung-kwan, 449-712, Gyeonggi-do (KR); Lee, Sang-yoon, 449-712, Gyeonggi-do (KR); Lee, Kwang-hee, 449-712, Gyeonggi-do (KR); Kim, Tae-sang, 449-712, Gyeonggi-do (KR); Kim, Eok-su, 449-712, Gyeonggi-do (KR); Son, Kyoung-seok, 449-712, Gyeonggi-do (KR); Maeng, Wan-joo, 449-712, Gyeonggi-do (KR); Park, Joon-seok, 449-712, Gyeonggi-do (KR)
(74) Representative: Mullen, Lee Bryan

(56) References cited:
- EP-A1- 2 161 756
- EP-A2- 2 061 087
- US-A1- 2010 026 169
- US-A1- 2010 051 933

## Description

### BACKGROUND

Example embodiments relate to transistors, methods of manufacturing the transistors and electronic devices including the transistors.

Transistors are widely used as switching devices or driving devices in electronic devices. In particular, because thin film transistors (TFTs) may be formed on glass substrates or plastic substrates, TFTs are generally used in flat panel devices such as liquid crystal display devices, organic light-emitting display devices and/or the like.

Commercialized flat panel display devices may include a thin film transistor having a channel layer formed of amorphous silicon (hereinafter referred to as amorphous silicon thin film transistor), and/or a thin film transistor having a channel layer formed of a poly-crystalline silicon layer (hereinafter referred to as poly-crystalline silicon thin film transistor).

However, a charge mobility of the amorphous silicon thin film transistor may be low at about 0.5 cm²/Vs, and thus it may be difficult to increase an operating speed of a flat panel display device. In addition, because an optical band gap of amorphous silicon is about ∼ 1.8 eV, a leakage current may be generated and dangling bonds (i.e., chemical bonds that do not join another atom) may be increased due to irradiation of visible light. The characteristics of the amorphous silicon thin film transistor may be deteriorated.

In the case of a poly-crystalline silicon thin film transistor, a crystallization process, an impurity implanting process, and an activation process may be required. The manufacturing process thereof may be complicated and expensive compared to an amorphous silicon thin film transistor. In addition, crystal grains of a poly-crystalline silicon layer may not be uniform and when the poly-crystal silicon layer is used as a channel layer of a large size display device the quality of a screen image may decrease.

A transistor including a channel layer formed of an oxide layer, referred to as an oxide thin film transistor, is being researched. Oxide thin film transistors may be of large size, low cost, high performance, and high reliability.

US 2010/0051933 discloses a thin film transistor array substrate includes: an insulating substrate; a gate electrode formed on the insulating substrate; an oxide semiconductor layer comprising a lower oxide layer formed on the gate electrode and an upper oxide layer formed on the lower oxide layer, such that the oxygen concentration of the upper oxide layer is higher than the oxygen concentration of the lower oxide layer; and a source electrode and a drain electrode formed on the oxide semiconductor layer and separated from each other.

EP 2 061 087 discloses a TFT which includes on a substrate, at least a gate electrode, a gate insulating layer, an active layer containing an amorphous oxide semiconductor, a source electrode, and a drain electrode, wherein a mean square interface roughness between the gate insulating layer and the active layer is less than 2 nm, a carrier concentration of the active layer is 1x10¹⁵ cm⁻³ or more, and a film thickness of the active layer is 0.5 nm or more and less than 20 nm.

### SUMMARY

Example embodiments may include transistors of high and/or increased performance and high and/or increased reliability, methods of manufacturing the transistors, and electronic devices including the transistors.

According example embodiments, a transistor according to claim 1 is provided. The first layer may be a conductor that is depleted according to a gate voltage condition and the second layer may have a lower electric conductivity than that of the first layer.

An oxygen vacancy concentration of the first layer may be higher than an oxygen vacancy concentration of the second layer. An electrical conductivity of the second layer may be greater than or equal to 10⁻⁸ S/cm and less than 10³ S/cm. A carrier concentration of the first layer may be greater than or equal to 10¹⁸/ cm³ and less than or equal to 10²¹/ cm³. A carrier concentration of the second layer may be greater than or equal to 10¹³/ cm³ and less than 10¹⁸/ cm³. The first layer may have a thickness of about 5 nm to about 50 nm.

The first layer and the second layer may include the same metal composition. The first layer and the second layer may have the same metal concentration. The gate may be disposed under the channel layer. The transistor may further include an etch stop layer formed on the channel layer. The gate may be disposed over the channel layer. According to other example embodiments, a flat panel display device may include the above-described transistor.

According to yet other example embodiments, a method of manufacturing a transistor according to claim 9 is provided.

The first layer may be formed at a first oxygen partial pressure and the second layer may be formed at a second oxygen partial pressure that is greater than the first oxygen partial pressure. A reaction gas used in the forming the channel layer may include O₂ and Ar, and the first layer may be formed under a condition that a flow rate of O₂ to Ar (O₂/Ar) is greater than 0 and less than 0.1, and the second layer may be formed under a condition that a flow rate of O₂ to Ar (O₂/Ar) is greater than or equal to 0.1. The first layer and the second layer may be formed using an in-situ method. An oxygen vacancy concentration of the first layer may be higher than that of the second layer.

An electrical conductivity of the first layer is greater than or equal to 10³ S/cm. An electrical conductivity of the second layer may be greater than or equal to 10⁻⁸ S/cm and less than 10³ S/cm. The first layer may be formed to have a thickness of about 5 nm to about 50 nm. The transistor may be formed to have a bottom gate structure or a top gate structure.

According to further example embodiments, a transistor includes a channel layer including first and second layers, the first layer configured to switch between a normally conductive state and a depletion state according to a voltage bias, a conductivity of the second layer less than a conductivity of the first layer in the conductive state, the channel layer including an oxide, a source and a drain on the channel layer, a gate on the channel layer and a gate insulation layer between the first layer and the gate, the first layer between the second layer and the gate insulation layer.

According to still further example embodiments, methods of manufacturing transistors may include forming a gate, forming a channel layer including an oxide by sequentially forming first and second layers corresponding to the gate, the first layer formed to be switchable between a conductive state and a depletion state according to a voltage bias, the second layer formed with a conductivity that is less than a conductivity of the first layer in the conductive state, forming a gate insulation layer between the gate and the first layer and forming a source and drain on the channel layer.

### BRIEF DESCRIPTION OF THE DRAWINGS

Example embodiments will be more clearly understood from the following brief description taken in conjunction with the accompanying drawings. FIGS. 1-14 represent non-limiting, example embodiments as described herein.
FIGS. 1-5 are cross-sectional diagrams illustrating transistors according to example embodiments;
FIGS. 6A-6D are cross-sectional diagrams illustrating methods of manufacturing transistors according to example embodiments;
FIGS. 7A-7D are cross-sectional diagrams illustrating methods of manufacturing transistors according to other example embodiments;
FIG. 8 is a graph illustrating variation in electric characteristics of an oxide layer as a function of O₂/Ar flow rate in a method of manufacturing transistors according to example embodiments;
FIG. 9 is a graph illustrating variation in oxygen concentration of a channel layer as a function of depth into the channel layer for a channel layer formed using a method of manufacturing transistors according to example embodiments;
FIGS. 10-12 are graphs illustrating gate voltage (V_{GS})-drain current (I_{DS}) characteristics of a transistor according to example embodiments and a comparison example; and
FIGS. 13 and 14 are graphs illustrating variation in gate voltage (V_{GS})-drain current (I_{DS}) characteristics of transistors due to light irradiation according to example embodiments.

It should be noted that these figures are intended to illustrate the general characteristics of methods, structure and/or materials utilized in certain example embodiments and to supplement the written description provided below. These drawings are not, however, to scale and may not precisely reflect the precise structural or performance characteristics of any given embodiment, and should not be interpreted as defining or limiting the range of values or properties encompassed by example embodiments. For example, the relative thicknesses and positioning of molecules, layers, regions and/or structural elements may be reduced or exaggerated for clarity. The use of similar or identical reference numbers in the various drawings is intended to indicate the presence of a similar or identical element or feature.

### DETAILED DESCRIPTION

Example embodiments will now be described more fully with reference to the accompanying drawings, in which example embodiments are shown. Example embodiments may, however, be embodied in many different forms and should not be construed as being limited to the embodiments set forth herein; rather, these embodiments are provided so that this disclosure will be thorough and complete, and will fully convey the concept of example embodiments to those of ordinary skill in the art. In the drawings, the thicknesses of layers and regions are exaggerated for clarity. Like reference numerals in the drawings denote like elements, and thus their description will be omitted.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. As used herein the term "and/or" includes any and all combinations of one or more of the associated listed items. Other words used to describe the relationship between elements or layers should be interpreted in a like fashion (e.g., "between" versus "directly between," "adjacent" versus "directly adjacent," "on" versus "directly on").

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises", "comprising", "includes" and/or "including," if used herein, specify the presence of stated features, integers, steps, operations, elements and/or components, but do not preclude the presence or addition of one or more other features, integers, steps, operations, elements, components and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

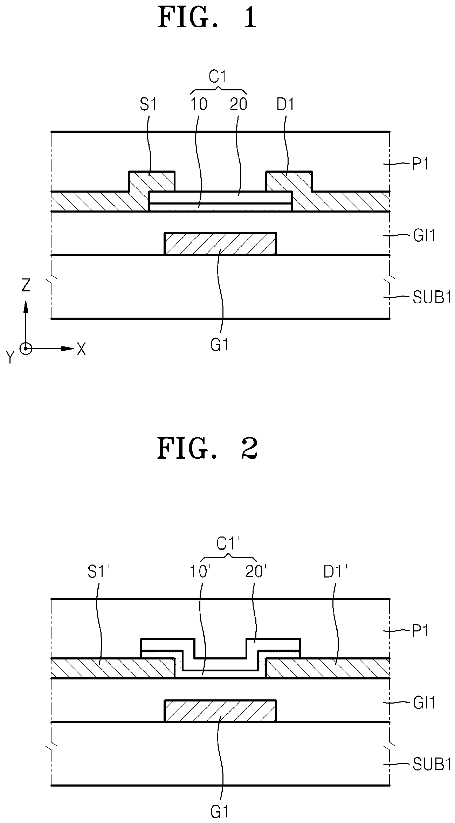

FIG. 1 is a cross-sectional diagram illustrating a transistor according to example embodiments. The transistor may be a bottom gate type thin film transistor in which a gate G1 is under a channel layer C1. Referring to FIG. 1, a gate G1 may be on a substrate SUB1. The substrate SUB1 may be a plastic substrate and/or another substrate that may be used in a semiconductor device process (e.g., a glass substrate and/or a silicon substrate). The gate G1 may be of a general electrode material (e.g., a metal, a conductive oxide and/or the like). A gate insulation layer GI1 covering the gate G1 may be on the substrate SUB1. The gate insulation layer GI1 may include, for example, a silicon oxide layer and/or a silicon nitride layer. The gate insulation layer GI1 may include, for example, a high-k dielectric layer with a higher dielectric constant than that of a silicon nitride layer. The gate insulation layer GI1 may be a single layer or a multi-layer structure.

A channel layer C1 may be on the gate insulation layer GI1. The channel layer C1 may be over the gate G1. A width of the channel layer C1 along an X-axis direction may be relatively greater than a width of the gate G1. The channel layer C1 is an oxide and is a multi-layer structure. The channel layer C1 includes a double-layer structure including a first oxide layer (hereinafter referred to as a first layer 10) and a second oxide layer (hereinafter referred to as a second layer 20). The first layer 10 and the second layer 20 may be sequentially stacked. The first layer 10 is nearer to the gate G1 than the second layer 20. The first layer 10 is between the gate insulation layer and the second layer 20. The first layer 10 may contact the gate insulation layer GI1 and the second layer 20 is separated from the gate insulation layer GI1. A thickness of the first layer 10 may be, for example, about 5 nm to about 50 nm. A thickness of the second layer 20 may be, for example, about 10 nm to about 1000 nm.

A source electrode S1 and a drain electrode D1 respectively contacting two ends of the channel layer C1 may be on the gate insulation layer GI1. The source electrode S1 and the drain electrode D1 may be single layer or multi-layer structures. The source electrode S1 and the drain electrode D1 may be of the same or similar material as that of the gate G1 and/or other materials. A passivation layer P1 covering the channel layer C1, the source electrode S1, and the drain electrode D1 may be on the gate insulation layer GI1. The passivation layer P1 may be, for example, a silicon oxide layer, a silicon nitride layer and/or an organic layer (e.g., a structure including at least two of these layers). Thicknesses of the gate G1, the gate insulation layer GI1, the source electrode S1, and the drain electrode D1 may be from about 50 nm to about 300 nm, from about 50 nm to about 400 nm, from about 10 nm to about 200 nm, and from about 10 nm to about 200 nm, respectively. The first layer 10 and the second layer 20 of the channel layer C1 may have different electrical characteristics.

The first layer 10 may be a conductor and has an electrical conductivity of 10³ S/cm or greater. A depletion region may be induced in the first layer 10 according to a voltage applied to the gate G1 (e.g., a gate voltage). For example, the first layer 10 may be depleted based on a gate voltage. The second layer 20 is a semiconductor with an electrical conductivity that is less than that of the first layer 10. For example, the electrical conductivity of the second layer 20 may be about 10⁻⁸ S/cm or greater. The electrical conductivity of the second layer 20 is less than about 10³ S/cm.

The electrical conductivities of the first and second layers 10 and 20 may be related to carrier concentrations thereof. A carrier concentration of the first layer 10 may be greater than or equal to about 10¹⁸/ cm³ and less than or equal to about 10²¹/ cm³. A carrier concentration of the second layer 20 may be greater than or equal to about 10¹³/cm³ and less than about 10¹⁸/ cm³. An electrical resistance of the first layer 10 may be about 10 Ωcm or less, and an electrical resistance of the second layer 20 may be greater than about 10 Ωcm. An oxygen vacancy concentration of the first layer 10 may be different from that of the second layer 20. For example, the oxygen vacancy concentration of the first layer 10 may be higher than that of the second layer 20. A large amount of oxygen vacancies may indicate that relatively few oxygen ions are present. An oxygen ion concentration of the first layer 10 may be less than an oxygen ion concentration of the second layer 20.

The first layer 10 may be a conductor that is electrically conductive when no external factors influence the first layer 10 (e.g., normally conductive). An external factor may influence the first layer 10 and the first layer 10 may lose its conductivity. For example, an external factor may induce characteristics similar to an insulator in the first layer 10. For example, when a negative (-) voltage is applied to the gate G1, as carriers (e.g., electrons) of the first layer 10 transfer to the second layer 20, the first layer 10 may be depleted (e.g., become a depletion region). In an OFF state where a negative (-) voltage is applied to the gate G1, the first layer 10 may have insulating characteristics. Because the first layer 10 is conductive in an ON state, a current between the source electrode S1 and the drain electrode D1 may mostly flow through the first layer 10.

Because the first layer 10 which has characteristics of a conductor may obtain the characteristics of an insulator through an external factor, the first layer 10 may function as a channel of a transistor for ON/OFF switching. If the first layer 10 is excessively thick, it may be difficult to form a depletion region in the first layer 10 even when a negative (-) voltage is applied to the gate G1. If the first layer 10 is excessively thick, it may be difficult to induce insulating characteristics in the first layer 10. The first layer 10 may be relatively thin. For example, the thickness of the first layer 10 may be from about 5 nm to about 50nm. The second layer 20 may be a thickness of about 10 nm to about 1000 nm.

The first layer 10 may be an oxide (e.g., metal oxide) of the same group as the second layer 20. Metal compositions of the first layer 10 and the second layer 20 may be the same or similar. Metal element concentrations of the first layer 10 and the second layer 20 may be the same or similar. The first layer 10 and the second layer 20 may be an oxide based on the same material, but the electrical characteristics thereof may be determined by oxygen vacancy concentrations (or oxygen ion concentrations) or carrier concentrations thereof. When the first layer 10 and the second layer 20 are formed of an oxide based on the same material, the first layer 10 and the second layer 20 may be formed using an in-situ method using one sputter target, thereby simplifying a manufacturing process. The first layer 10 and the second layer 20 include HfInZnO.

The channel layer C1 is a plurality of oxide layers, the first and second layers 10 and 20, which are of different electrical characteristics, and the operating characteristics and/or reliability of the transistor may be improved.

FIG. 2 is a cross-sectional diagram illustrating a transistor according to example embodiments. Referring to FIG. 2, a source electrode S1' and a drain electrode D1' spaced apart from each other may be on the gate insulation layer GI1. A channel layer C1' contacting the source electrode S1' and the drain electrode D1' may be formed on the gate insulation layer GI1 between the source electrode S1' and the drain electrode D1'. The source electrode S1' and the drain electrode D1' may contact two ends of a lower surface of the channel layer C1'. The channel layer C1' includes first and second layers 10' and 20' (e.g., sequentially stacked layers). The first and second layers 10' and 20' may be of the same or similar material as that of the first and second layers 10 and 20 described with respect to FIG. 1. The transistor of FIG. 2 may be the same or similar in structure to the transistor of FIG. 1, except the positions of the channel layer C1', the source electrode S1', and the drain electrode D1'.

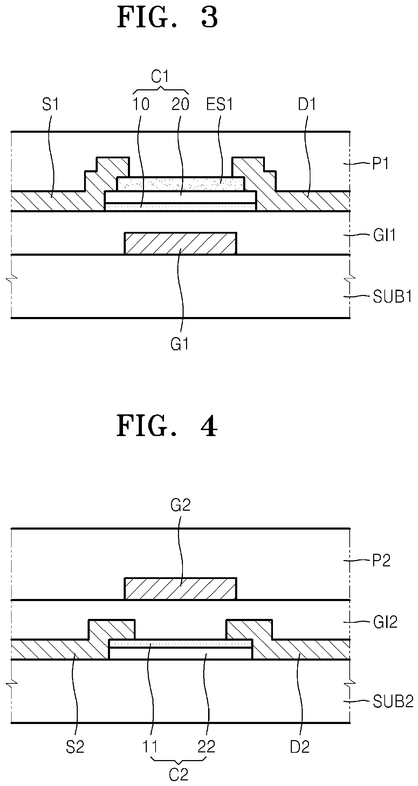

FIG. 3 is a cross-sectional diagram illustrating a transistor according to example embodiments. Referring to FIG. 3, the etch stop layer ES1 may be on the channel layer C1. A width of the etch stop layer ES1 along an X-axis direction (see the coordinates of FIG. 1) may be less than a width of the channel layer C1. Two ends of the channel layer C1 may not be covered by the etch stop layer ES1. The source electrode S1 may cover first ends of the etch stop layer ES1 and the channel layer C1, and the drain electrode D1 may cover second ends of the etch stop layer ES1 and the channel layer C1. During an etch process for forming the source electrode S1 and the drain electrode D1, the etch stop layer ES1 may prevent the channel layer C1 from being damaged by the etch process and/or reduce such damage. The etch stop layer ES1 may include, for example, a silicon oxide, a silicon nitride, and/or an organic insulation material. Whether to use the etch stop layer ES1 may be determined in consideration of the material of the channel layer C1 and the material of the source electrode S1 and the drain electrode D1. The structure of the transistor of FIG. 3 may be the same or similar to that of the transistor of FIG. 1, except for the etch stop layer ES1.

FIG. 4 is a cross-sectional diagram illustrating a transistor according to example embodiments. The transistor may be a top gate type thin film transistor in which a gate G2 is over a channel layer C2. Referring to FIG. 4, the channel layer C2 may be on a substrate SUB2. The channel layer C2 is an inverse structure of the channel layer C1 of FIG. 1. The channel layer C2 of FIG. 4 includes a second layer 22 corresponding to the second layer 20 of FIG. 1 and a first layer 11 corresponding to the first layer 10 of FIG. 1. The second layer 22 and the first layer 11 may be sequentially stacked on the substrate SUB2. The first layer 11 may be a conductor and the second layer 22 is a semiconductor. A source electrode S2 and a drain electrode D2 may be on the substrate SUB2 so as to contact two ends of the channel layer C2, respectively. A gate insulation layer GI2 covering the channel layer C2, the source electrode S2, and the drain electrode D2 may be on the substrate SUB2. The gate G2 may be formed on the gate insulation layer GI2. The gate G2 may be over the channel layer C2. A passivation layer P2 covering the gate G2 may be formed on the gate insulation layer GI2.

Materials and thicknesses of the substrate SUB2, the first layer 11, the second layer 22, the source electrode S2, the drain electrode D2, the gate insulation layer GI2, the gate G2, and the passivation layer P2 of FIG. 4 may be the same or similar to those of the substrate SUB1, the first layer 10, the second layer 20, the source electrode S1, the drain electrode D1, the gate insulation layer GI1, the gate G1, and the passivation layer P1, respectively, of FIG. 1. The function of the first layer 11 and the second layer 22 of FIG. 4 may be the same or similar to that of the first layer 10 and the second layer 20 of FIG. 1, respectively.

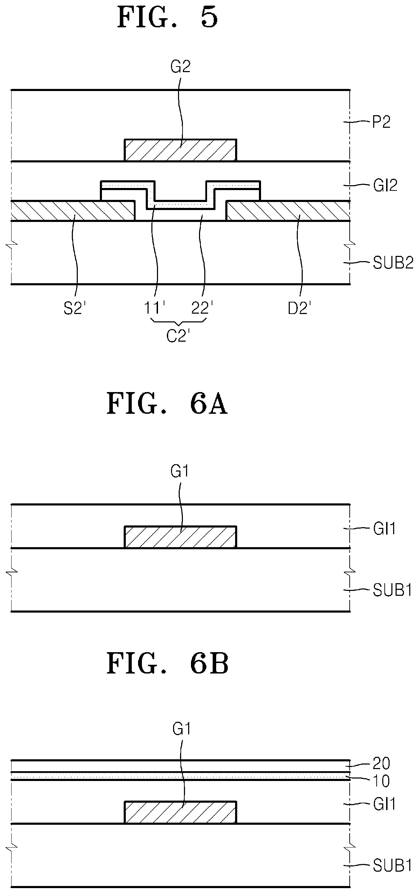

FIG. 5 is a cross-sectional diagram illustrating a transistor according to example embodiments. Referring to FIG. 5, a source electrode S2' and a drain electrode D2' spaced apart from each other may be on the substrate SUB2. A channel layer C2' contacting the source electrode S2' and the drain electrode D2' may be on the substrate SUB2 between the source electrode S2' and the drain electrode D2'. The source electrode S2' and the drain electrode D2' may respectively contact two ends of a lower surface of the channel layer C2'. The channel layer C2' includes a second layer 22' and a first layer 11' on the substrate SUB2 (e.g., sequentially stacked on the substrate SUB2). The first layer 11' and the second layer 22' may be, for example, of the same material as the first layer 11 and the second layer 22 of FIG. 4. The first layer 11' may be a conductor, and the second layer 22' is a semiconductor. The structure of the transistor of FIG. 5 may be the same or similar to that of the transistor FIG. 4, except the positions of the channel layer C2', the source electrode S2', and the drain electrode D2'.

FIGS. 6A-6D are cross-sectional diagrams illustrating methods of manufacturing transistors according to example embodiments. Reference numerals in FIGS. 6A-6D that are the same as reference numerals in FIG. 1 may denote like elements. Referring to FIG. 6A, a gate G1 may be formed on a substrate SUB1, and a gate insulation layer GI1 may be formed to cover the gate G1. The gate insulation layer GI1 may be formed to include, for example, a silicon oxide and/or a silicon nitride. The gate insulation layer GI1 may be formed to include, for example, a high-k electric material with a higher dielectric constant than that of a silicon nitride. The gate insulation layer GI1 may be a single layer or a multi-layer structure.

Referring to FIG. 6B, an oxide thin film for forming a channel with a multi-layer structure is formed on the gate insulation layer GI1. For example, a first oxide layer (hereinafter referred to as a first layer 10) and a second oxide layer (hereinafter referred to as a second layer 20) are formed (e.g., sequentially formed). The first layer 10 and the second layer 20 may be deposited, for example, using a physical vapor deposition (PVD) method (e.g., a sputtering method and/or an evaporation method). The first layer 10 and the second layer 20 are formed of an oxide (e.g., metal oxide) based on the same group (material). The first layer 10 and the second layer 20 may be of the same metal composition. The first layer 10 and the second layer 20 may be of the same or similar metal element concentrations. The first layer 10 and the second layer are formed of HfInZnO.

When the first layer 10 and the second layer 20 are formed of an oxide based on the same material, they may be formed at different oxygen partial pressures. The first layer 10 may be formed at a first oxygen partial pressure, and the second layer 20 may be formed at a second oxygen partial pressure that is greater than the first oxygen partial pressure. When forming the first layer 10 and the second layer 20, a reaction gas including O₂ and Ar may be used. In this case, the oxygen partial pressures may be adjusted by varying a flow rate of O₂ gas and Ar gas. The first layer 10 may be formed under a condition that a flow rate of O₂ to Ar (O₂/Ar is greater than 0 and smaller than 0.1. The second layer 20 may be formed under a condition that a flow rate of O₂ to Ar (O₂/Ar is 0.1 or greater.

By forming the first layer 10 and the second layer 20 at different oxygen partial pressures, the first layer 10 and the second layer 20 may formed with different electrical characteristics. According to the above-described method, the first layer 10 is formed as an electrical conductor with an electrical conductivity of about 10³ S/cm or greater. The second layer 20 is formed as a semiconductor of less electrical conductivity than that of the first layer 10. For example, the electrical conductivity of the second layer 20 may be greater than or equal to about 10⁻⁸ S/cm and is less than about 10³ S/cm.

A carrier concentration of the first layer 10 may be greater than or equal to about 10¹⁸/ cm³ and less than or equal to about 10²¹/ cm³. A carrier concentration of the second layer 20 may be greater than or equal to about 10¹³/ cm³ and less than about 10¹⁸/ cm³. An electrical resistance of the first layer 10 may be about 10 Ωcm or less, and an electrical resistance of the second layer 20 may be greater than about 10 Ωcm. An oxygen vacancy concentration of the first layer 10 may differ from that of the second layer 20. For example, the oxygen vacancy concentration of the first layer 10 may be higher than that of the second layer 20. An oxygen ion concentration of the first layer 10 may be less than that of the second layer 20. The first layer 10 may be formed to a thickness of about 5 nm to about 50 nm. The second layer 20 may be formed to a thickness of about 10 nm to about 1000 nm.

When the first layer 10 and the second layer 20 are formed of an oxide based on the same material, the first layer 10 and the second layer 20 may be formed using an in-situ method using one sputter target by differentiating process conditions. The manufacturing process may be simplified. Using the methods according to example embodiments, mass production of transistors may be facilitated and transistors with a large surface area may be manufactured. The first layer 10 and the second layer 20 may be, for example, formed at different oxygen partial pressures. The first layer 10 and the second layer 20 with different properties may be formed, for example, by varying a chamber pressure and/or a source power. The first layer 10 and the second layer 20 may be formed at varying oxygen partial pressures or at a fixed oxygen partial pressure, while varying a chamber pressure and/or source power. The first layer 10 and the second layer 20 may be formed of an oxide based on the same material. The first layer 10 and the second layer 20 may be formed of oxides based on different materials.

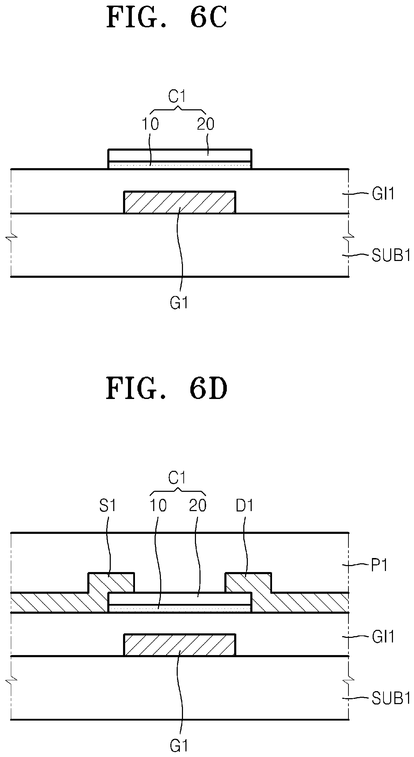

Referring to FIG. 6C, a channel layer C1 may be formed by patterning the first layer 10 and the second layer 20. The patterned first layer 10 may be the same or similar to the first layer 10 of FIG. 1, and the patterned second layer 20 may be the same or similar to the second layer 20 of FIG. 1. Referring to FIG. 6D, a source electrode S1 and a drain electrode D1 respectively contacting two ends of the channel layer C1 and exposing a portion of an upper surface of the channel layer C1 may be formed on the gate insulation layer GI1. The source electrode S1 and the drain electrode D1 may be a single layer or a multi-layer structure. The exposed portion of the channel layer C1 that is not covered by the source electrode S1 and the drain electrode D1 may be treated with plasma containing oxygen.

A passivation layer P1 covering the exposed portion of the channel layer C1 and the source electrode S1 and the drain electrode D1 may be formed on the substrate SUB1. The passivation layer P1 may be a silicon oxide layer, a silicon nitride layer, and/or an organic layer, for example, a structure including at least two of these layers. The transistor formed as described above may be thermally annealed. Transistors with the structure of FIGS. 2 and 3 may be formed by modified examples of the method illustrated in FIGS. 6A-6D. One of ordinary skill in the art will understand how to manufacture transistors with the structure of FIGS. 2 and 3 with knowledge of the methods illustrated in FIGS. 6A-6D, thus descriptions thereof will be omitted.

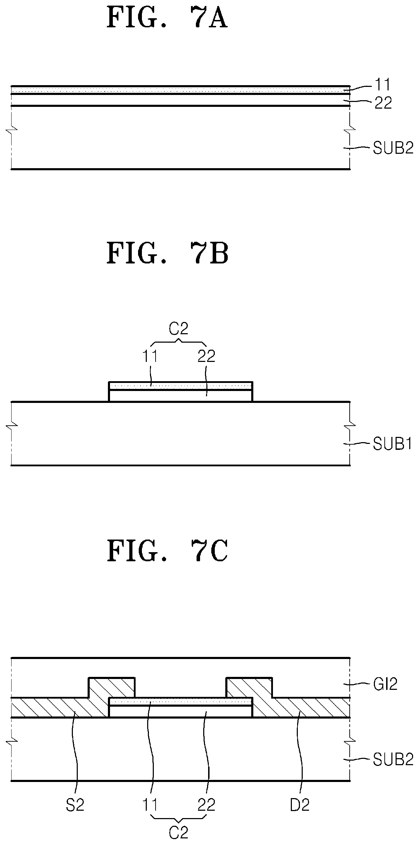

FIGS. 7A-7D are cross-sectional diagrams illustrating methods of manufacturing transistors according to example embodiments. Reference numerals in FIGS. 7A -7D that are the same as reference numerals in FIG. 4 may denote like elements. Referring to FIG. 7A, an oxide thin film for forming a channel with a multi-layer structure is formed on a substrate SUB2. For example, a second oxide layer (hereinafter referred to as a second layer 22) and a first oxide layer (hereinafter referred to as a first layer 11) may be sequentially formed. The first layer 11 and the second layer 22 may be the same or similar to the first layer 10 and the second layer 20 of FIG. 6B. The material, the fabrication method, and the thicknesses of the first layer 11 and the second layer 22 may be the same or similar to those of the first layer 10 and the second layer 20 of FIG. 6B.

A channel layer C2 as illustrated in FIG. 7B may be formed by patterning the first layer 11 and the second layer 22. The channel layer C2 has an inverse structure of the channel layer C1 of FIG. 6C. Referring to FIG. 7C, a source electrode S2 and a drain electrode D2 respectively contacting two ends of the channel layer C2 may be formed on the substrate SUB2. An exposed portion of the channel layer C2 that is not covered by the source electrode S2 and the drain electrode D2 may be treated with, for example, plasma containing oxygen. A gate insulation layer GI2 covering the exposed portion of the channel layer C2 and the source electrode S2 and the drain electrode D2 may be formed on the substrate SUB2. The gate insulation layer GI2 may be formed of the same or similar material to that of the gate insulation layer GI1 of FIG. 6A. The gate insulation layer GI2 may be formed as a same or similar structure to that of the gate insulation layer GI1 of FIG. 6A. The gate insulation layer GI2 may be formed as an inverse structure of the gate insulation layer GI1 of FIG. 6A.

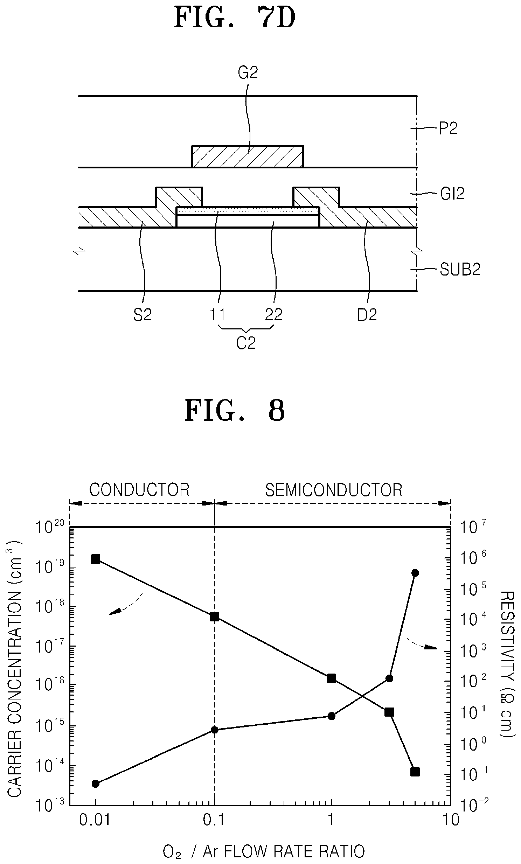

Referring to FIG. 7D, a gate G2 may be formed on the gate insulating layer GI2. The gate G2 may be over the channel layer C2. A passivation layer P2 may be formed on the gate insulating layer GI2 to cover the gate G2. The passivation layer P2 may be formed of the same or similar material and the same or similar stacked structure as the passivation layer P1 of FIG. 6D. A transistor formed as described above may be thermally annealed. A transistor with the structure of FIG. 5 may be formed by modifying the manufacturing method illustrated in FIGS. 7A-7D. One of ordinary skill in the art will understand how to manufacture transistors with the structure of FIG. 5 with knowledge of the methods illustrated in FIGS. 7A-7D, thus descriptions thereof will be omitted.

FIG. 8 is a graph illustrating variation in electric characteristics of an oxide layer as a function of O₂/Ar flow rate during deposition of an oxide layer. The oxide layer may be for forming a channel in a method of manufacturing transistors according to example embodiments. The oxide layer is HfInZnO. Referring to FIG. 8, as the O₂/Ar flow rate increases, a carrier concentration of the oxide layer may be reduced and electrical resistance thereof may be increased. When the O₂/Ar flow rate is less than about 0.1, an oxide layer with conductor characteristics may be formed. When the O₂/Ar flow rate is about 0.1 or greater, an oxide layer with semiconductor characteristics may be formed. With respect to FIGS. 6B and 7A, the first layers 10 and 11 may be formed at a O₂/Ar flow rate that is greater than 0 and less than about 0.1, and the second layers 20 and 22 may be formed at a O₂/Ar flow rate that is about 0.1 or greater.

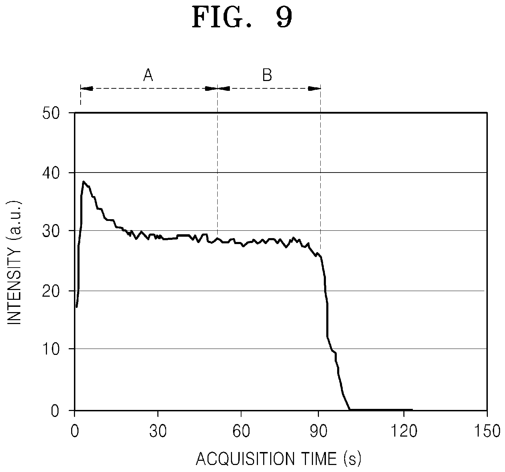

FIG. 9 is a graph illustrating variation in oxygen concentration of a channel layer as a function of depth into the channel layer for a channel layer formed using a method of manufacturing transistors according to example embodiments. The channel layer is formed of HfInZnO. In FIG. 9, a region A may correspond to a semiconductor region (e.g., the second layer 20 of FIG. 1) and a region B may correspond to a conductor region (e.g., the first layer 10 of FIG. 1). In FIG. 9, an X-axis may denote an acquisition time in seconds (s). The longer the acquisition time, the greater the measured depth of the channel layer becomes. Referring to FIG. 9, an oxygen concentration of the region B, the conductor region, may be relatively lower than that of the region A, the semiconductor region. The difference in the oxygen concentrations may be one of the factors that generate the difference in the electrical characteristics of the region A (e.g., the second layer 20 of FIG. 1) and the region B (e.g., the first layer 10 of FIG. 1).

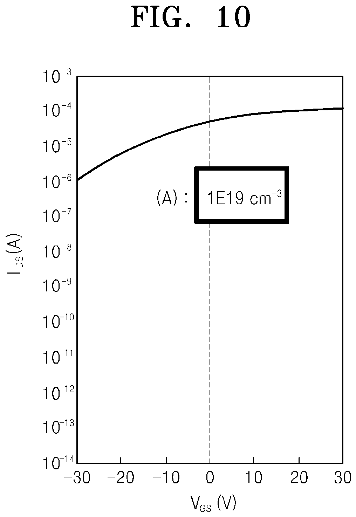

FIGS. 10-12 are graphs illustrating gate voltage (V_{GS})-drain current (I_{DS}) characteristics of a transistor according to example embodiments and a comparison example. The structure of the transistor according to example embodiments may be the structure of FIG. 3 and includes a double-layer channel. The structure of the transistor according to the comparison example may be similar to the structure of FIG. 3 and may include a single layer channel. Material for the channel layers of both transistors is HfInZnO. The characteristics (carrier concentration), thicknesses, and formation conditions (O₂/Ar flow rate) of the channel layers may be shown in Table 1 below.

**[Table 1]**

| | | Carrier concentration (/cm³) | Thickness (nm) | O₂/Ar flow rate |
|---|---|---|---|---|
| Comparison example (single layer channel) | A | 10¹⁹ | 40 | 0.01 |
| | B | 10¹⁴ | 40 | 1 |
| | C | 10¹⁵ | 40 | 5 |
| Example embodiments (double-layer channel) | A / B | 10¹⁹ / 10¹⁴ | 10 / 30 | 0.01 / 1 |
| | A / C | 10¹⁹ / 10¹⁵ | 10 / 30 | 0.01 / 5 |

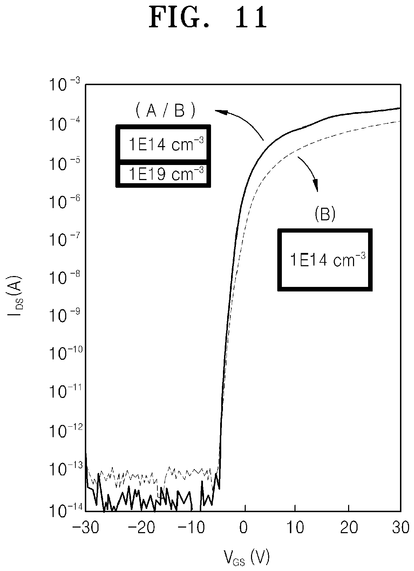

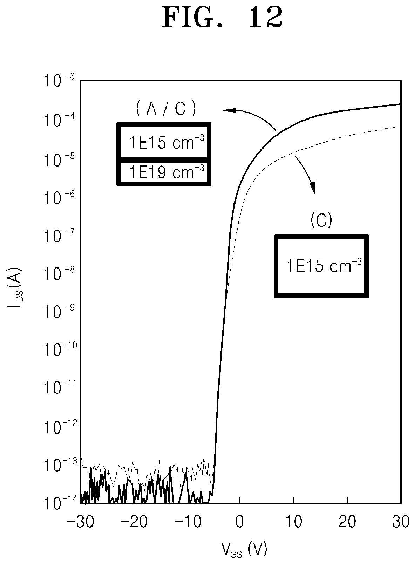

Referring to FIG. 10, according to the comparison example including a channel A, the whole channel layer may be a conductor and no switching characteristics are displayed. Referring to FIG. 11, according to example embodiments in which a channel A/B is included, a higher ON current and a lower OFF current may be shown than the comparison example including a channel B. This indicates that the mobility of the transistor including the channel A/B may be higher that the comparison example including the channel B, and the on/off current ratio of the transistor including the channel A/B may be higher than the transistor of the comparison example including the channel B. Referring to FIG. 12, according to example embodiments including a channel A/C, a higher ON current and a lower OFF current may be achieved than the comparison example including a channel C. This is similar to the result of FIG. 11.

The results of FIGS. 10-12 may be summarized as shown in Table 2 below.

**[Table 2]**

| | | Mobility (cm²/Vs) | Threshold voltage (V) |
|---|---|---|---|
| Comparison example (single layer channel) | A | (conductor) | |
| | B | 6.57 | -0.27 |
| | C | 4.47 | -1.79 |
| Example embodiments (double-layer channel) | A / B | 21.18 | -2.90 |
| | A / C | 18.48 | -3.11 |

As described above, according to example embodiments, an oxide thin film transistor with excellent and/or improved operating characteristics, for example, high and/or improved mobility and high and/or improved ON/OFF current ratio, may be manufactured. The increased mobility may be due to the conductive characteristics of the first layer 10.

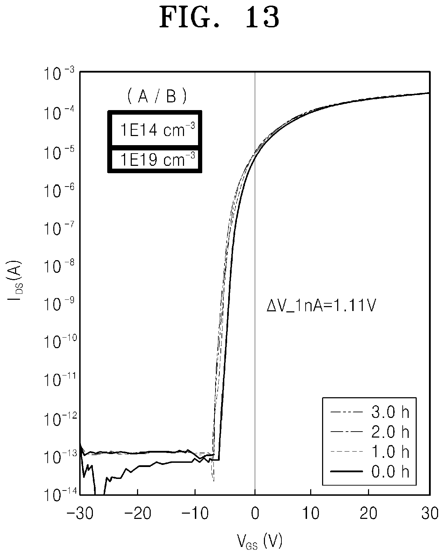

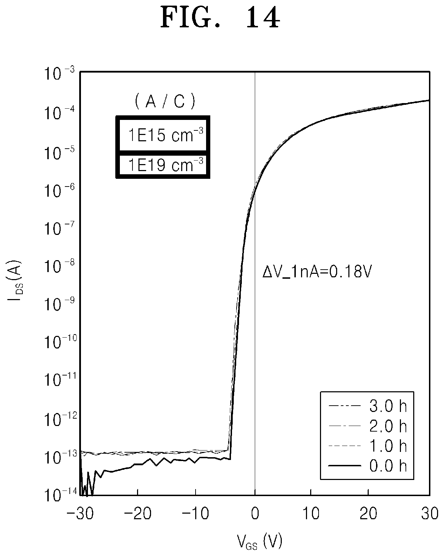

FIGS. 13 and 14 are graphs illustrating variation in gate voltage (V_{GS})-drain current (I_{DS}) characteristics of a transistor due to light irradiation according to example embodiments. The channel layers of these example embodiments may be the same as those of the example embodiments of Table 1. By irradiating light of about 120 lux to the transistors and respectively applying voltages of -20 V, 10 V, and 0 V to a gate, a drain electrode, and a source electrode of the transistors, variation in the characteristics of the transistors according to time may be measured.

Referring to FIGS. 13 and 14, variation in the characteristics of the transistor due to light irradiation may be small and/or decreased. In FIG. 13, ΔV_1nA is about 1.11 V. In FIG. 14, ΔV_1nA is about 0.18 V. The reference character "ΔV_1nA" may denote a difference in 'V_1nA' before and after light irradiation, calculated as [V_1nA(after) - V_1nA(before)]. The term 'V_1nA' may denote a gate voltage that allows a current of 1 nA to flow between the source and drain electrodes. The higher the absolute value of "ΔV_1nA", the greater the variation in the characteristics of the transistors due to light irradiation. The results of FIGS. 13 and 14 may indicate that the light reliability (photo reliability) of the transistors of example embodiments is good and/or improved. Referring to FIG. 14, ΔV_1nA may be almost 0. With respect to a conventional transistor including a channel layer formed of an oxide layer, because an oxide may be sensitive to light, variation in the characteristics of the transistor may be generated by light irradiation.

According to example embodiments, a plurality of oxide layers with different characteristics are used and a decrease in the reliability of the general oxide transistor may be prevented and/or reduced. An oxide thin film transistor according to example embodiments may exhibit high and/or improved performance, and high and/or improved reliability. An oxide thin film transistor according to example embodiments may exhibit high and/or improved mobility, and high and/or improved on/off current ratio. An oxide thin film transistor according to example embodiments may exhibit reduced variation in the characteristics thereof due to light.

The transistors according to example embodiments may be used as switching devices or driving devices of flat panel display devices, for example, liquid crystal display devices and/or organic light emitting display devices. Transistors according to example embodiments may show small variation in characteristics due to light and good and/or improved operating characteristics. When the transistors are used in flat panel display devices, the reliability and performance of the flat panel display devices may be improved. The structures of the liquid crystal display devices and the organic light emitting display devices are well known in the art, and thus description thereof will be omitted. The transistors according to example embodiments may be applied not only to flat panel display devices but also to other various electronic devices, for example, memory devices and logic devices, for various purposes.

While example embodiments have been particularly shown and described, it will be understood by one of ordinary skill in the art that variations in form and detail may be made therein without departing from the scope of the claims. For example, it will be understood by those skilled in the art that various changes in form and details of the elements and structure of the transistors of FIGS. 1-5 of example embodiments may be made. The channel layers C1, C1', C2, and C2' may have a multi-layer structure including at least three layers, or oxygen vacancy concentrations thereof (or oxygen ion concentrations) may gradually vary in a direction of deposition, that is, a thickness direction thereof. The transistors according to example embodiments may have a double-gate structure. The methods illustrated in FIGS. 6A-6D and in FIGS. 7A-7D may be modified in various ways.

## Claims

1. A transistor comprising:
a channel layer (C1, C1', C2) including first (10, 11) and second oxide layers (20, 22), the first layer configured to switch between a normally conductive state and a depletion state according to a voltage bias, a conductivity of the second layer less than a conductivity of the first layer in the conductive state;
a source (S1, S1', S2) and a drain (D1, D1', D2) contacting opposite ends of the channel layer;
a gate (G1, G1', G2) facing the channel layer; and
a gate insulation layer (GI1, GI2) located between the first layer and the gate,
wherein the first layer is located between the second layer and the gate insulation layer, **characterized in that** first and second layers include HfInZnO and an electrical conductivity of the first layer is equal or greater to 10³ S/cm.

2. The transistor of claim 1, wherein an oxygen vacancy concentration of the first layer (10, 11) is higher than an oxygen vacancy concentration of the second layer (20, 22).

3. The transistor of claim 1 or 2, wherein a thickness of the first layer (10, 11) is 5 nm to 50 nm.

4. The transistor of any of claims 1-3, wherein the first layer (10, 11) and the second layer (20,22) include a same metal composition.

5. The transistor of any of claims 1-3, wherein a metal concentration of the first layer (10, 11) is the same as a metal concentration of the second layer (20, 22).

6. The transistor of any of claims 1-5, wherein the gate (G1) is a top gate or a bottom gate, the transistor optionally further comprising an etch stop layer (ES1) on the channel layer (C1) in case the gate is a bottom gate.

7. The transistor of any of claims 1-6, wherein the first layer (10, 11) is insulative in the depletion state.

8. A flat panel display comprising the transistor of any of claims 1-7.

9. A method of manufacturing a transistor, the method comprising:
forming a gate (G1, G1', G2);
forming a channel layer (C1, C1', C2) by sequentially forming first (10, 11) and second oxide layers (20, 22) facing the gate, the first layer formed to be switchable between a conductive state and a depletion state according to a voltage bias, the second layer formed with a conductivity that is less than a conductivity of the first layer in the conductive state, the first and second layer being formed to include HfInZnO and an electrical conductivity of the first layer being equal or greater to 10³ S/cm;
forming a gate insulation layer (GI1, GI2) between the gate and the first layer; and
forming a source (S1, S1', S2) and drain (D1, D1', D2) contacting opposite ends of the channel layer.

10. The method of claim 9, wherein the forming of the channel layer (C1, C1', C2) includes forming the first layer (10, 11) at a first oxygen partial pressure, and forming the second layer (20, 22) at a second oxygen partial pressure that is greater than the first oxygen partial pressure.

11. The method of claim 10, wherein the forming of the channel layer (C1, C1') includes using a reaction gas including O₂ and Ar,
forming the first layer (10, 11) at an O₂ to Ar (O₂/Ar flow rate of greater than 0 and less than 0.1, and
forming the second layer (20, 22) at an O₂ to Ar (O₂/Ar flow rate of greater than or equal to 0.1.

12. The method of claim 9, wherein the forming of the first (10, 11) and second layers (20, 22) using an in-situ process optionally including only varying one or more of oxygen partial pressure, chamber pressure and source power.

13. The method of any of claims 9-12, wherein the forming of the channel layer (C1, C1', C2) includes forming the first layer (10,11) to a thickness of 5 nm to 50 nm.

## Patentansprüche

1. Transistor, umfassend:
eine Kanalschicht (C1, C1', C2) enthaltend erste (10, 11) und zweite Oxidschichten (20, 22), wobei die erste Schicht konfiguriert ist, um zwischen einem normal leitfähigen Zustand und einem Verarmungszustand gemäß einer Vorspannung umzuschalten, eine Leitfähigkeit der zweiten Schicht weniger als eine Leitfähigkeit der ersten Schicht im leitfähigen Zustand ist; eine Quelle (S1, S1', S2) und eine Entladung (D1, D1', D2) gegenüberliegende Enden der Kanalschicht kontaktieren;
ein Gatter (G1, G1', G2) gegenüber der Kanalschicht; und
eine Gatterisolierschicht (GI1, GI2) zwischen der ersten Schicht und dem Gatter, wobei sich die erste Schicht zwischen der zweiten Schicht und der Gatterisolierschicht befindet, **dadurch gekennzeichnet, dass** die erste und zweite Schicht HfInZnO enthalten und eine elektrische Leitfähigkeit der ersten Schicht gleich wie oder größer als 10³ S/cm ist.

2. Transistor nach Anspruch 1, wobei eine sauerstofffreie Konzentration der ersten Schicht (10, 11) höher als eine sauerstofffreie Konzentration der zweiten Schicht (20, 22) ist.

3. Transistor nach Anspruch 1 oder 2, wobei eine Stärke der ersten Schicht (10, 11) 5 nm bis 50 nm ist.

4. Transistor nach einem der Ansprüche 1-3, wobei die erste Schicht (10, 11) und die zweite Schicht (20,22) eine gleiche Metallzusammensetzung enthalten.

5. Transistor nach einem der Ansprüche 1-3, wobei eine Metallkonzentration der ersten Schicht (10, 11) gleich wie die Metallkonzentration der zweiten Schicht (20, 22) ist.

6. Transistor nach einem der Ansprüche 1-5, wobei das Gatter (G1) ein oberes Gatter oder ein unteres Gatter ist, wobei der Transistor optional ferner eine geätzte Stoppschicht (ES1) an der Kanalschicht (C1) umfasst, wenn das Gatter ein unteres Gatter ist.

7. Transistor nach einem der Ansprüche 1-6, wobei die erste Schicht (10, 11) im Verarmungszustand isolierend ist.

8. Flachbildschirm umfassend den Transistor nach einem der Ansprüche 1 -7.

9. Verfahren zum Herstellen eines Transistors, das Verfahren umfassend: Bilden eines Gatters (G1, G1', G2);
Bilden einer Kanalschicht (C1, C1', C2) durch aufeinanderfolgendes Bilden erster (10, 11) und zweiter Oxidschichten (20, 22) gegenüber dem Gatter, wobei die erste Schicht gebildet ist, um zwischen einem leitfähigen Zustand und einem Verarmungszustand gemäß einer Vorspannung umschaltbar zu sein, die zweite Schicht mit einer Leitfähigkeit gebildet ist, die weniger als eine Leitfähigkeit der ersten Schicht im leitfähigen Zustand ist, wobei die erste und zweite Schicht gebildet sind, um HfInZnO zu enthalten, und eine elektrische Leitfähigkeit der ersten Schicht gleich wie oder größer als 10³ S/cm ist;
Bilden einer Gatterisolierschicht (GI1, GI2) zwischen dem Gatter und der ersten Schicht; und
Bilden einer Quelle (S1, S1', S2) und Entladung (D1, D1', D2), die gegenüberliegende Enden der Kanalschicht kontaktieren.

10. Verfahren nach Anspruch 9, wobei das Bilden der Kanalschicht (C1, C1', C2) ein Bilden der ersten Schicht (10, 11) bei einem ersten Sauerstoffteildruck und Bilden der zweiten Schicht (20, 22) bei einem zweiten Sauerstoffteildruck, der größer als der erste Sauerstoffteildruck ist, enthält.

11. Verfahren nach Anspruch 10, wobei das Bilden der Kanalschicht (C1, C1') eine Verwendung eines Reaktionsgases einschließlich O₂ und Ar enthält,
ein Bilden der ersten Schicht (10, 11) bei einer Durchflussrate O₂ zu Ar (O₂/Ar) größer als 0 und weniger als 0,1, und
ein Bilden der zweiten Schicht (20, 22) bei einer Durchflussrate O₂ zu Ar (O₂/Ar) größer als oder gleich 0,1.

12. Verfahren nach Anspruch 9, wobei das Bilden der ersten (10, 11) und zweiten Schichten (20, 22) unter Verwendung eines lokalen Prozesses optional nur ein Variieren von einem oder mehreren von Sauerstoffteildruck, Kammerdruck und Quellenleitung enthält.

13. Verfahren nach einem der Ansprüche 9-12, wobei das Bilden der Kanalschicht (C1, C1', C2) ein Bilden der ersten Schicht (10,11) mit einer Stärke von 5 nm bis 50 nm enthält.

## Revendications

1. Transistor, comprenant :
une couche canal (C1, C1', C2) comprenant des première (10,11) et deuxième (20, 22) couches d'oxyde, la première couche étant configurée pour effectuer une commutation entre un état normalement conducteur et un état appauvri, en fonction d'une tension de polarisation, une conductivité de la deuxième couche inférieure à une conductivité de la première couche, à l'état conducteur ; une source (S1, S1', S2) et un drain (D1, D1', D2) contactant des bouts opposés de la couche canal ;
une grille (G1, G1', G2) faisant face à la couche canal ; et
une couche d'isolation de grille (GI1, GI2) étant située entre la première couche et la grille, la première couche étant située entre la deuxième couche et la couche d'isolation de grille, **caractérisée en ce que** les première et deuxième couches comprennent du HfInZnO, et une conductivité électrique de la première couche étant égale ou supérieure à 10³ S/cm.

2. Transistor selon la revendication 1, une concentration de lacune d'oxygène de la première couche (10, 11) étant supérieure à une concentration de lacune d'oxygène de la deuxième couche (20, 22)

3. Transistor selon la revendication 1 ou 2, une épaisseur de la première couche (10, 11) étant comprise entre 5 nm et 50 nm.

4. Transistor selon une quelconque des revendications 1 à 3, la première couche (10, 11) et la deuxième couche (20, 22) ayant la même composition métallique.

5. Transistor selon une quelconque des revendications 1 à 3, une concentration métallique de la première couche (10, 11) étant la même qu'une concentration métallique de la deuxième couche (20, 22).

6. Transistor selon une quelconque des revendications 1 à 5, la grille (G1) étant une grille supérieure ou une grille inférieure, le transistor comprenant de plus, en option, une couche d'arrêt de gravure (ES1) sur la couche canal (C1) dans l'éventualité où la grille soit une grille inférieure.

7. Transistor selon une quelconque des revendications 1 à 6, la première couche (10, 11) étant isolante à l'état appauvri.

8. Un écran plat comprenant le transistor d'une quelconque des revendications 1 à 7.

9. Méthode de fabrication d'un transistor, la méthode comprenant :
la formation d'une grille (G1, G1', G2) ;
la formation d'une couche canal (C1, C1', C2) en formant les première (10, 11) et deuxième (20, 22) couches oxydes faisant face à la grille, la première couche étant commutable entre un état conducteur et un état appauvri en fonction d'une tension de polarisation, la deuxième couche étant formée avec une conductivité inférieure à une conductivité de la première couche, à l'état conducteur, les première et deuxième couches étant formées pour comprendre du HfInZnO, et une conductivité électrique de la première couche étant égale ou supérieure à 10³ S/cm ;
la formation d'une couche d'isolation de grille (GI1, GI2) entre la première couche et la grille ; et la formation d'une source (S1, S1', S2) et d'un drain (D1, D1', D2) contactant des bouts opposés de la couche canal.

10. Méthode selon la revendication 9, la formation de la couche canal (C1, C1', C2) comprenant la formation de la première couche (10, 11) à une première pression partielle d'oxygène, et la formation de la deuxième couche (20, 22) à une deuxième pression partielle d'oxygène supérieure à la première pression partielle d'oxygène.

11. Méthode selon la revendication 10, la formation de la couche canal (C1, C1') comprenant l'utilisation d'un gaz de réaction comprenant de l'O₂ et de l'Ar,
la formation de la première couche (10, 11) avec un débit O₂ à Ar (O₂/Ar) supérieur à 0 et inférieur à 0,1, et
la formation de la deuxième couche (20, 22) avec un débit O₂ à Ar (O₂/Ar) supérieur ou égal à 0,1.

12. Méthode selon la revendication 9, la formation des première (10, 11) et deuxième (20, 22) couches en utilisant un procédé in-situ comprenant en option la variation d'une ou plusieurs des suivantes : pression partielle d'oxygène, pression de la chambre, et source d'énergie.

13. Méthode selon une quelconque des revendications 9 à 12, la formation de la couche canal (C1, C1', C2) comprenant la formation de la première couche (10, 11) avec une épaisseur comprise entre 5 nm et 50 nm.
